# EUROPEAN PATENT SPECIFICATION

(11) **EP 4 206 707 B1**
(45) Date of publication and mention of the grant of the patent: **12.02.2025**
(21) Application number: 22811583.8
(22) Date of filing: 20.05.2022
(51) Int. Cl.: G01R 31/36, G01R 31/392, G01R 31/382, H01M 10/48, H01M 10/42, H01M 10/44

(54) **BATTERY MONITORING APPARATUS AND METHOD**
VORRICHTUNG UND VERFAHREN ZUR BATTERIEÜBERWACHUNG
APPAREIL ET PROCÉDÉ DE SURVEILLANCE DE BATTERIE

(30) Priority: 26.05.2021 KR 20210067882
(43) Date of publication of application: 05.07.2023
(73) Proprietor: LG Energy Solution, Ltd., Seoul 07335 (KR)
(72) Inventor: KIM, Chang-Hoon, Daejeon 34122 (KR)
(74) Representative: Hoffmann Eitle
(86) International application number: PCT/KR2022/007258
(87) International publication number: WO 2022/250390

(56) References cited:
- CN-A- 109 932 658
- CN-A- 112 240 986
- CN-A- 112 703 125
- KR-A- 20110 000 558
- KR-A- 20120 099 583
- KR-A- 20130 031 858
- KR-A- 20170 023 583
- KR-A- 20200 123 658
- US-A1- 2017 259 687
- US-A1- 2021 109 160

## Description

### TECHNICAL FIELD

The present application claims priority to Korean Patent Application No. 10-2021-0067882 filed on May 26, 2021 in the Republic of Korea.

The present disclosure relates to a battery monitoring apparatus and method, and more particularly, to a battery monitoring apparatus and method, which may monitor a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

However, an internal short circuit may occur in the battery due to various causes, and in severe cases, there is a risk that a fire may occur. Typically, when lithium metal is precipitated inside the battery, an internal short circuit may occur in the battery. For example, if an internal short circuit may occur in the battery provided in an electric vehicle and the battery is continuously operated, there is a risk that a fire may occur in the electric vehicle.

In order to solve this problem, the technique of detecting whether a battery is short-circuited has been researched in the prior art, see e.g. US 2017/259687 A1 which discloses a battery monitoring apparatus for a vehicle which includes a controller configured to, in response to a rate of change of voltage vs. a state of charge during discharge of a battery cell exceeding a first threshold more than a predetermined number of times over a predefined duration, output an error signal, and in response to the rate of change exceeding a second threshold greater than the first, output the error signal. The error signal indicates the detection of lithium plating on the battery electrodes. However, there is a limit in accurately detecting whether a battery provided in an electric vehicle or an energy storage system is short-circuited in a non-destructive manner.

### DISCLOSURE

### Technical Problem

The present disclosure is designed to solve the problems of the related art, and therefore the present disclosure is directed to providing a battery monitoring apparatus and method, which may monitor whether lithium is precipitated based on a voltage and a state of charge (SOC) of the battery.

These and other objects and advantages of the present disclosure may be understood from the following detailed description and will become more fully apparent from the exemplary embodiments of the present disclosure.

### Technical Solution

A battery monitoring apparatus according to one aspect of the present disclosure may comprise: a profile generating unit configured to generate a differential profile representing a corresponding relationship between a differential voltage representing a change rate of a voltage of a battery to a SOC of the battery and the SOC; and a control unit configured to calculate a curvature corresponding to a preset SOC region in the differential profile, compare the calculated curvature with a preset criterion curvature for the battery, and judge whether lithium is precipitated in the battery based on the comparison result.

The control unit may be configured to compare magnitudes of the calculated curvature and the criterion curvature.

The control unit may be configured to judge that lithium is not precipitated in the battery, when the calculated curvature is equal to or smaller than the criterion curvature.

The control unit may be configured to judge that lithium is precipitated in the battery, when the calculated curvature is greater than the criterion curvature.

The control unit may be configured to calculate the number of times that the calculated curvature is greater than the criterion curvature and judge whether lithium is precipitated in the battery based on the calculated number of times.

The control unit may be configured to judge that lithium is precipitated in the battery, when the calculated number of times is greater than a preset criterion value.

The profile generating unit may be configured to generate a plurality of differential profiles.

The control unit may be configured to calculate the curvature in each of the plurality of differential profiles generated by the profile generating unit and calculate the number of times that the plurality of calculated curvatures are greater than the criterion curvature.

When the calculated number of times is greater than a preset criterion value, the control unit may be configured to determine an increase/decrease pattern for a curvature judged as being greater than the criterion curvature and judge whether lithium is precipitated in the battery based on the determined increase/decrease pattern.

The control unit may be configured to judge that lithium is precipitated in the battery, when the determined increase/decrease pattern is an increase pattern.

When it is judged that lithium is precipitated in the battery, the control unit may be configured to generate and output a diagnosis code related to the lithium precipitation.

The control unit may be configured to calculate an idle period of the battery and calculate the curvature for the differential profile generated by the profile generating unit when the calculated idle period is equal to or smaller than a preset criterion period.

The control unit may be configured to determine a target peak included in the preset SOC region of the differential profile and calculate a curvature corresponding to the target peak.

A battery pack according to another aspect of the present disclosure may comprise the battery monitoring apparatus according to an aspect of the present disclosure.

A vehicle according to another aspect of the present disclosure may comprise the battery monitoring apparatus according to an aspect of the present disclosure.

A method for diagnosing a state of a battery according to another aspect of the present disclosure may comprise: a differential profile generating step of generating a differential profile representing a corresponding relationship between a differential voltage representing a change rate of a voltage of a battery to a SOC of the battery and the SOC; a curvature calculating step of calculating a curvature corresponding to a preset SOC region in the differential profile generated in the differential profile generating step; a curvature comparing step of comparing the curvature calculated in the curvature calculating step with a preset criterion curvature for the battery; and a lithium precipitation judging step of judging whether lithium is precipitated in the battery based on the comparison result of the curvature comparing step.

### Advantageous Effects

According to one aspect of the present disclosure, it is possible to monitor whether lithium is precipitated in a battery in a non-destructive manner. Accordingly, it is possible to prevent a short circuit of the battery from occurring due to lithium precipitation and prevent a fire from occurring due to the generated short circuit.

The effects of the present disclosure are not limited to the above, and other effects not mentioned herein will be clearly understood by those skilled in the art from the appended claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery monitoring apparatus according to an embodiment of the present disclosure.
FIG. 2 is a diagram schematically showing a differential profile of a first battery according to an embodiment of the present disclosure.
FIG. 3 is a diagram schematically showing a differential profile of a second battery according to another embodiment of the present disclosure.
FIG. 4 is a diagram schematically showing a differential profile of a third battery according to still another embodiment of the present disclosure.
FIG. 5 is a diagram schematically showing a plurality of curvatures for a fourth battery according to still another embodiment of the present disclosure.
FIG. 6 is a diagram schematically showing an exemplary configuration of a battery pack including the battery monitoring apparatus according to an embodiment of the present disclosure.
FIG. 7 is a diagram schematically showing a battery monitoring method according to another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

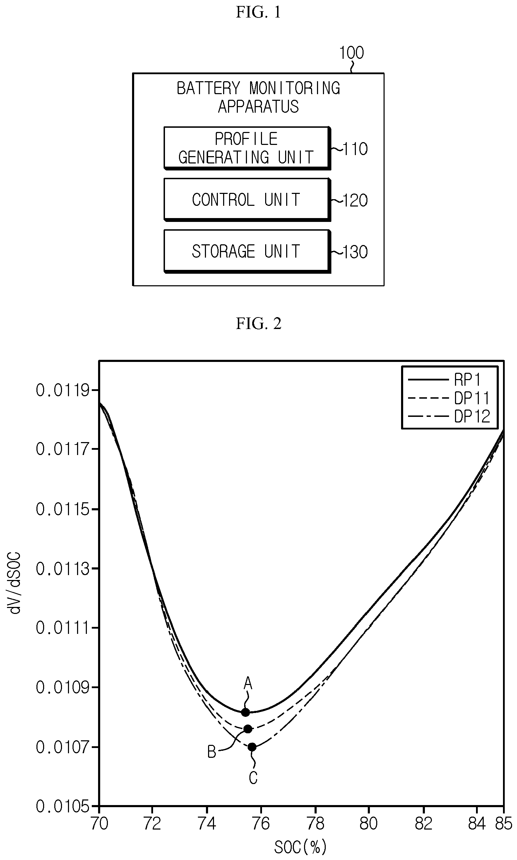

FIG. 1 is a diagram schematically showing a battery monitoring apparatus 100 according to an embodiment of the present disclosure.

Referring to FIG. 1, the battery monitoring apparatus 100 may include a profile generating unit 110 and a control unit 120.

The profile generating unit 110 may be configured to generate a differential profile representing a corresponding relationship between a differential voltage representing a change rate of a voltage of a battery to a state of charge (SOC) of the battery and the SOC.

Here, the battery refers to one physically separable independent cell having a negative electrode terminal and a positive electrode terminal. For example, a lithium-ion battery or a lithium polymer cell may be regarded as the battery. In addition, the battery may refer to a battery module in which a plurality of cells are connected in series and/or in parallel. Hereinafter, for convenience of description, the battery will be described as meaning one independent cell.

Specifically, the profile generating unit 110 may obtain battery information about the SOC and voltage of the battery. In addition, the profile generating unit 110 may calculate a differential voltage (dV/dSOC) representing a change rate of a voltage corresponding to each SOC. In addition, the profile generating unit 110 may generate a differential profile representing a corresponding relationship between the SOC and the differential voltage.

For example, the profile generating unit 110 may first generate a battery profile representing a corresponding relationship between the SOC and voltage based on the obtained battery information. In addition, the profile generating unit 110 may calculate a differential voltage for each SOC and generate a differential profile representing a corresponding relationship between the SOC and the differential voltage.

FIG. 2 is a diagram schematically showing a differential profile of a first battery according to an embodiment of the present disclosure. Specifically, FIG. 2 is a diagram showing the SOC 70% to 85% region in the differential profile of the first battery.

In the embodiment of FIG. 2, the criterion differential profile RP1 may be generated when the first battery is in a BOL (Beginning of life) state. Here, the criterion differential profile RP1 may be generated in the outside in advance and obtained by the profile generating unit 110, or may be directly generated by the profile generating unit 110 based on the BOL data of the first battery.

In addition, in the embodiment of FIG. 2, the first differential profile DP11 and the second differential profile DP12 may be generated at a predetermined time interval. For example, the second differential profile DP12 may be generated at a time point that 3 days have elapsed after the first differential profile DP11 is generated.

The control unit 120 may be configured to calculate a curvature corresponding to a preset SOC region in the differential profile. Hereinafter, it is assumed that the curvature corresponding to the preset SOC region in the criterion profile RP1 is preset.

Specifically, the control unit 120 may be configured to determine a target peak included in the preset SOC region of the differential profile.

For example, the preset SOC region may be set as a SOC 50% to 100% region. Preferably, the SOC region may be set as an SOC 70% to 85% region.

Here, the peak may mean a point at which the instantaneous change rate is 0 in the differential profile. That is, in the differential profile, the point at which the instantaneous change rate of the differential voltage with respect to the SOC is 0 may be determined as a peak.

The control unit 120 may determine at least one peak in the preset SOC region in consideration of the instantaneous change rate of the differential voltage for the SOC. In addition, the control unit 120 may determine a peak having the lowest differential voltage among the determined peaks as the target peak.

Preferably, the target peak may be determined in the SOC 70% to 85% region. In addition, the control unit 120 may determine at least one peak having a downwardly convex shape in the preset SOC region in order to quickly determine the target peak. That is, since the target peak means a peak having the lowest differential voltage, the control unit 120 may determine a peak having a downwardly convex shape as a candidate group for the target peak, excluding the peak having an upwardly convex shape.

For example, in the embodiment of FIG. 2, the control unit 120 may determine the first target peak B in the first differential profile DP11 for the first battery. In addition, the control unit 120 may determine the second target peak C in the second differential profile DP12 for the first battery.

The control unit 120 may be configured to calculate a curvature corresponding to the target peak.

For example, the control unit 120 may calculate a circle of curvature inscribed in the determined target peak, and calculate the inverse of the curvature radius (the radius of the calculated circle of curvature) as a curvature corresponding to the target peak. Here, when one or more circles of curvature inscribed in the target peak are calculated, the control unit 120 may select the circle of curvature having the largest curvature radius, and select the curvature corresponding to the target peak according to the curvature radius of the selected circle of curvature. That is, the control unit 120 may calculate the minimum curvature for the target peak as a curvature corresponding to the target peak.

In the embodiment of FIG. 2, the control unit 120 may calculate a first curvature corresponding to the first target peak B in the first differential profile DP11. Also, the control unit 120 may calculate a second curvature corresponding to the second target peak C in the second differential profile DP12.

The control unit 120 may be configured to compare the calculated curvature with a preset criterion curvature for the battery. Specifically, the control unit 120 may be configured to compare the magnitudes of the calculated curvature and the criterion curvature.

For example, in the embodiment of FIG. 2, the criterion curvature for the first battery may be preset based on a curvature corresponding to the criterion peak A of the criterion differential profile RP1. Preferably, the criterion curvature for the first battery may be preset as a curvature corresponding to the criterion peak A.

The control unit 120 may compare the magnitudes of the criterion curvature and the first curvature and the magnitudes of the criterion curvature and the second curvature, respectively.

The control unit 120 may be configured to judge whether lithium is precipitated in the battery based on the comparison result.

For example, if the calculated curvature is smaller than or equal to the criterion curvature, the control unit 120 may be configured to judge that lithium is not precipitated in the battery. Conversely, if the calculated curvature is greater than the criterion curvature, the control unit 120 may be configured to judge that lithium is precipitated in the battery.

For example, in the embodiment of FIG. 2, the magnitude of the criterion curvature corresponding to the criterion peak A may be smaller than the magnitude of the first curvature corresponding to the first target peak B and the second curvature corresponding to the second target peak C. Therefore, the control unit 120 may judge that lithium is precipitated in the first battery. Specifically, the control unit 120 may judge that lithium plating (Li-plating) in which lithium metal is precipitated in the negative electrode of the first battery has occurred.

That is, the battery monitoring apparatus 100 according to an embodiment of the present disclosure may judge whether lithium is precipitated in a non-destructive manner based on the change behavior of the SOC and differential voltage that appear when lithium is precipitated in the battery. Therefore, since it is possible to monitor whether lithium is precipitated in the battery even if the battery is not directly disassembled, an internal short circuit caused by lithium precipitation and a fire accident caused by the internal short circuit may be prevented in advance.

Meanwhile, the control unit 120 included in the battery monitoring apparatus 100 may optionally include an application-specific integrated circuit (ASIC), another chipset, a logic circuit, a register, a communication modem, and a data processing device, and the like, known in the art to execute various control logics disclosed below. In addition, when the control logic is implemented in software, the control unit 120 may be implemented as a set of program modules. In this case, the program module may be stored in a memory and executed by the control unit 120. The memory may be inside or outside the control unit 120, and may be connected to the control unit 120 by various well-known means.

In addition, the battery monitoring apparatus 100 may further include a storage unit 130. The storage unit 130 may store programs, data and the like required for diagnosing a state of a battery according to the present disclosure. That is, the storage unit 130 may store data necessary for operation and function of each component of the battery monitoring apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile generating unit 110 and the control unit 120 are defined.

For example, the storage unit 130 may store battery information about the voltage and SOC of the battery. The profile generating unit 110 may directly obtain battery information from the outside, or may access the storage unit 130 to obtain the battery information. In addition, the profile generating unit 110 may generate a differential profile based on the obtained battery information. In this process, a program code or the like for generating a differential profile from the battery information may be stored in the storage unit 130.

In addition, the storage unit 130 may store the differential profile generated by the profile generating unit 110. The control unit 120 may receive the differential profile directly from the profile generating unit 110, or may access the storage unit 130 to obtain the stored differential profile.

The control unit 120 may be configured to calculate an idle period of the battery. Here, the idle period may mean a period in which the battery is maintained in an idle state. That is, the idle period may mean a period in which the battery is in a no-load state. The control unit 120 may calculate the idle period of the battery in consideration of whether the battery is being charged or discharged.

Specifically, as the idle period of the battery becomes longer, the battery may be stabilized. In this case, even if the control unit 120 calculates the curvature corresponding to the target peak from the differential profile for the battery, the difference between the calculated curvature and the criterion curvature may not appear significantly. Accordingly, the control unit 120 may be configured to calculate a curvature for the differential profile generated by the profile generating unit 110 when the calculated idle period is smaller than or equal to the preset criterion period.

In addition, the control unit 120 may further consider a preset threshold value in judging whether lithium is precipitated by comparing the magnitudes of the calculated curvature and the criterion curvature.

For example, if the difference between the calculated curvature and the criterion curvature is smaller than a threshold value, the control unit 120 may be configured to judge that lithium is not precipitated in the battery. Conversely, if the difference between the calculated curvature and the criterion curvature is equal to or greater than the threshold value, the control unit 120 may be configured to judge that lithium is precipitated in the battery.

In the embodiment of FIG. 2, the first battery may be in a state in which the idle period is smaller than or equal to the preset criterion period. In addition, the first differential profile DP11 and the second differential profile DP12 may be generated based on the SOC and voltage of the first battery whose idle period is smaller than or equal to the preset criterion period. Accordingly, if the difference between the first curvature corresponding to the first target peak B and the second curvature corresponding to the second target peak C is greater than or equal to the threshold value, the control unit 120 may judge that lithium is precipitated in the first battery. Conversely, if both the difference between the first curvature and the criterion curvature and the difference between the second curvature and the criterion curvature are smaller than the threshold value, the control unit 120 may judge that lithium is not precipitated in the first battery.

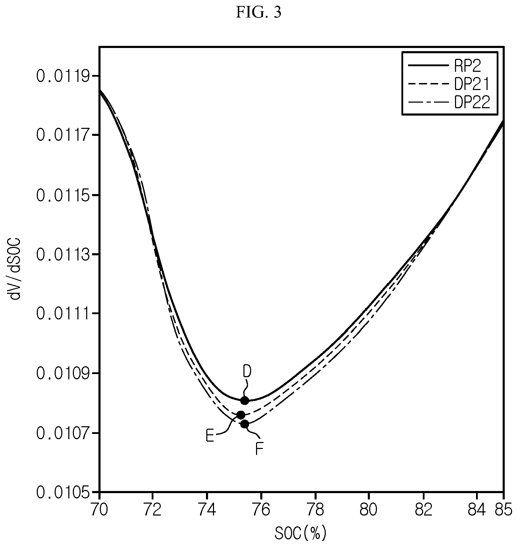

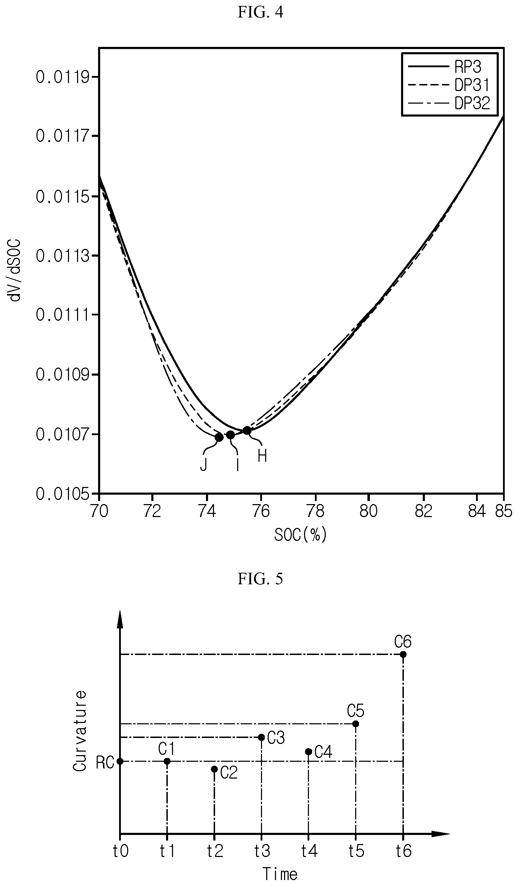

FIG. 3 is a diagram schematically showing a differential profile of a second battery according to another embodiment of the present disclosure. FIG. 4 is a diagram schematically showing a differential profile of a third battery according to still another embodiment of the present disclosure.

In the embodiment of FIG. 3, the criterion profile RP2 is a profile generated to correspond to the SOC and voltage of the second battery in the BOL state, the first differential profile DP21 is a profile generated to correspond to the SOC and voltage of the second battery at a predetermined first time point, and the second differential profile DP22 is a profile generated to correspond to the SOC and voltage of the second battery at a predetermined second time point.

In the embodiment of FIG. 4, the criterion profile RP3 is a profile generated to correspond to the SOC and voltage of the third battery in the BOL state, the first differential profile DP31 is a profile generated to correspond to the SOC and voltage of the third battery at a predetermined first time point, and the second differential profile DP32 is a profile generated to correspond to the SOC and voltage of the third battery at a predetermined second time point.

Specifically, in the embodiment of FIG. 3, the state of the second battery is a state in which the idle period is smaller than the preset criterion period at the first time point and the second time point, but in the embodiment of FIG. 4, the state of the third battery may be a state in which the idle period is greater than the preset criterion period. In addition, the second battery and the third battery may be in a state adjusted to maintain substantially the same degradation state.

Referring to FIG. 3, the difference between the first curvature corresponding to the first target peak E of the second battery and the criterion curvature corresponding to the criterion peak D may be greater than or equal to a threshold value. Also, the difference between the second curvature corresponding to the second target peak F of the second battery and the criterion curvature corresponding to the criterion peak D may be greater than or equal to a threshold value. Accordingly, the control unit 120 may judge that lithium is precipitated in the second battery.

Conversely, referring to FIG. 4, the difference between the first curvature corresponding to the first target peak I of the third battery and the criterion curvature corresponding to the criterion peak H may be smaller than the threshold value. In addition, the difference between the second curvature corresponding to the second target peak J of the third battery and the criterion curvature corresponding to the criterion peak H may be smaller than the threshold value. Therefore, the control unit 120 may judge that lithium is not precipitated in the third battery.

That is, since the idle period of the second battery is maintained to be equal to or smaller than the preset criterion period, the difference between the criterion curvature (curvature corresponding to the criterion peak D) and each of the first curvature (curvature corresponding to the first target peak E) and the second curvature (curvature corresponding to the second target peak F) may be equal to or greater than the threshold value. Meanwhile, in the third battery, the difference between the criterion curvature (curvature corresponding to the criterion peak H) and each of the first curvature (curvature corresponding to the first target peak I) and the second curvature (curvature corresponding to the second target peak J) may be smaller than the threshold value because the idle period is maintained to be greater than the preset criterion period.

Therefore, the battery monitoring apparatus 100 has an advantage of more accurately monitoring the state of the battery by judging whether lithium is precipitated in the battery in consideration of the idle period of the battery.

In another embodiment, the control unit 120 may be configured to calculate the number of times that the calculated curvature is greater than the criterion curvature. Hereinafter, an embodiment in which the calculated curvature is greater than the criterion curvature will be described, but it should be noted that the same may be identically applied to an embodiment in which the difference between the calculated curvature and the criterion curvature is smaller than the threshold value.

For example, for the battery in the BOL state, the number of times that the curvature is greater than the criterion curvature may be set to 0.

First, the profile generating unit 110 may be configured to generate a plurality of differential profiles.

For example, if the profile generating unit 110 obtains battery information about the SOC and voltage measured in the process of discharging the battery, a differential profile may be generated based on the obtained battery information. That is, since the differential profile may be generated when the battery is discharged, the differential profile may be generated periodically or aperiodically.

The control unit 120 may be configured to calculate a curvature in each of the plurality of differential profiles generated by the profile generating unit 110. In addition, the control unit 120 may be configured to calculate the number of times that the calculated plurality of curvatures is greater than the criterion curvature.

FIG. 5 is a diagram schematically showing a plurality of curvatures for a fourth battery according to still another embodiment of the present disclosure.

In the embodiment of FIG. 5, the fourth battery may be in a BOL state at a time point t0. That is, the curvature corresponding to the criterion peak of the fourth battery may be RC.

In addition, the profile generating unit 110 may generate a total of six differential profiles at the time points t1, t2, t3, t4, t5 and t6. The control unit 120 may calculate a curvature in each of the six differential profiles.

Specifically, the first curvature corresponding to the first target peak of the fourth battery at the time point t1 may be C1. The second curvature corresponding to the second target peak of the fourth battery at the time point t2 may be C2. The third curvature corresponding to the third target peak of the fourth battery at the time point t3 may be C3. The fourth curvature corresponding to the fourth target peak of the fourth battery at the time point t4 may be C4. The fifth curvature corresponding to the fifth target peak of the fourth battery at the time point t5 may be C5. The sixth curvature corresponding to the sixth target peak of the fourth battery at the time point t6 may be C6. The criterion profile and the first to sixth differential profiles for the fourth battery are not shown, but it should be noted that they may be inferred through the criterion profiles A, D, H, the first differential profiles B, E, I and the second differential profiles C, F, J.

In addition, in the embodiment of FIG. 5, the curvature greater than the criterion curvature RC may be the third curvature C3, the fourth curvature C4, the fifth curvature C5, and the sixth curvature C6. Accordingly, the control unit 120 may calculate that the number of times in which the calculated curvature C1, C2, C3, C4, C5, C6 is greater than the criterion curvature RC is 4.

In addition, the control unit 120 may be configured to judge whether lithium is precipitated in the battery based on the calculated number of times.

Specifically, if the calculated number of times is greater than a preset criterion value, the control unit 120 may be configured to judge that lithium is precipitated in the battery.

Here, the criterion value may be preset to correspond to the specifications, usage, and the like of the battery. For example, it is assumed that the criterion value is set to 3 in the embodiment of FIG. 5. Since the calculated number of times (4) is greater than the criterion value (3), the control unit 120 may judge that lithium is precipitated in the fourth battery.

That is, if lithium metal is precipitated in the battery, a short circuit may occur in the corresponding battery, and there is a risk of fire or explosion due to such a short circuit. Therefore, the battery diagnosed as lithium metal is precipitated is treated as an unused battery, for which inspection or replacement is demanded.

Therefore, the battery monitoring apparatus 100 may reduce the possibility of erroneously diagnosing the state of the battery by conservatively judging whether lithium metal is precipitated in the battery based on the number of times that the calculated curvature is greater than the criterion curvature. Here, the erroneous diagnosis may mean that a normal battery in which lithium metal is not precipitated is erroneously diagnosed as a battery in which lithium metal is precipitated.

In another embodiment, the control unit 120 may be configured to determine an increase/decrease pattern for the curvature judged as being greater than the criterion curvature, when the calculated number of times is greater than the preset criterion value.

Here, the increase/decrease pattern may be determined as an increase pattern or a decrease pattern depending on whether the value of the curvature judged as being greater than the criterion curvature increases.

Specifically, the increase pattern may be a pattern in which the value of the curvature judged as being greater than the criterion curvature increases. Conversely, the decrease pattern may be a pattern in which the value of the curvature judged as being greater than the criterion curvature is the same or decreased. That is, in order to conservatively judge whether lithium metal is precipitated in the battery, the decrease pattern may be determined even when the value of the curvature judged as being greater than the criterion curvature remains the same.

As in the previous embodiment, in the embodiment of FIG. 5, the curvature judged as being greater than the criterion curvature is the third curvature C3, the fourth curvature C4, the fifth curvature C5, and the sixth curvature C6, and the calculated number of times (4) is greater than the criterion value (3). Thus, the control unit 120 may determine the increase/decrease pattern of the third to sixth curvatures C3, C4, C5, C6. The fourth curvature C4 decreases below the third curvature C3, but the fifth curvature C5 increases above the third curvature C3 and the fourth curvature C4, and the sixth curvature C6 also increases above the fifth curvature C5. Thus, the control unit 120 may determine that the increase/decrease pattern of the third to sixth curvatures C3, C4, C5, C6 is the increase pattern.

The control unit 120 may be configured to judge whether lithium is precipitated based on the determined increase/decrease pattern.

Specifically, if the determined increase/decrease pattern is the increase pattern, the control unit 120 may be configured to judge that lithium is precipitated in the battery. Conversely, if the determined increase/decrease pattern is the decrease pattern, the control unit 120 may be configured to judge that lithium is not precipitated in the battery.

For example, in the embodiment of FIG. 5, the control unit 120 may determine that the increase/decrease pattern of the third to sixth curvatures C3, C4, C5, C6 is the increase pattern. Accordingly, the control unit 120 may judge that lithium metal is precipitated in the fourth battery.

That is, the battery monitoring apparatus 100 may judge whether lithium is precipitated in the battery by further considering not only the number of times that the calculated curvature is greater than the criterion curvature but also the increase/decrease pattern of the calculated curvatures. Therefore, it is possible to more conservatively judge whether lithium metal is precipitated in the battery, so the possibility of erroneous diagnosis may be lowered.

The control unit 120 may be configured to generate and output a diagnosis code related to lithium precipitation when it is judged that lithium is precipitated in the battery.

Here, the diagnosis code is a diagnostic trouble code (DTC), and may be a standardized failure diagnosis code representing a diagnosis result for the battery.

Specifically, the control unit 120 may output information representing that lithium is precipitated in the battery by outputting the diagnosis code. In addition, the control unit 120 may output battery identification information or the like along with the diagnosis code to specify a battery in which lithium is precipitated.

For example, the control unit 120 may output the generated diagnosis code to a communicatively connected server and/or user terminal. In addition, the control unit 120 may store the generated diagnosis code in the storage unit 130.

That is, the control unit 120 may output the generated diagnosis code to the outside to inform the diagnosis result of the state of the battery, and store the generated diagnosis code in the storage unit 130 to accumulatively store the battery usage history.

The battery monitoring apparatus 100 according to the present disclosure may be applied to a BMS (Battery Management System). That is, the BMS according to the present disclosure may include the above-described battery monitoring apparatus 100. In this configuration, at least some of the components of the battery monitoring apparatus 100 may be implemented by supplementing or adding functions of the configuration included in a conventional BMS. For example, the profile generating unit 110, the control unit 120 and the storage unit 130 of the battery monitoring apparatus 100 may be implemented as components of the BMS.

In addition, the battery monitoring apparatus 100 according to the present disclosure may be provided to a battery pack. For example, the battery pack according to the present disclosure may include the battery monitoring apparatus 100 as described above and at least one battery cell. In addition, the battery pack may further include electrical equipment (a relay, a fuse, etc.), a case, and the like.

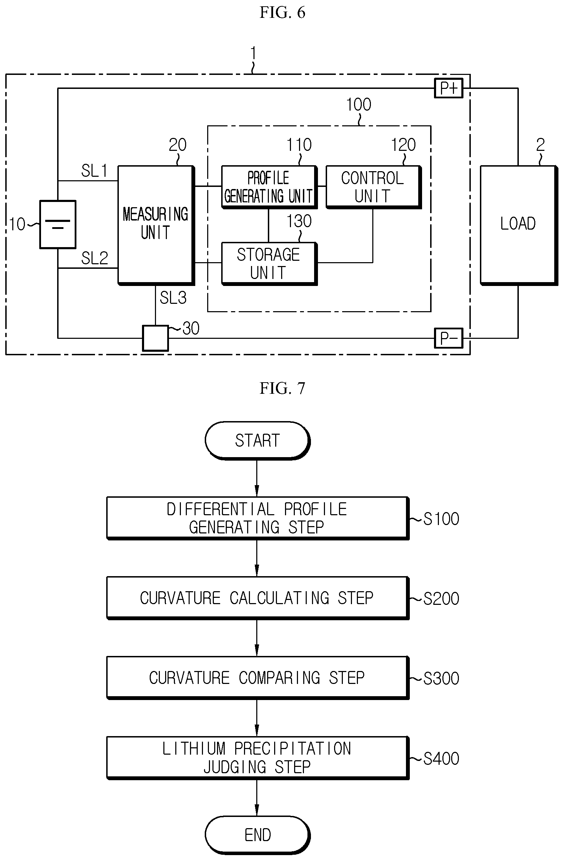

FIG. 6 is a diagram schematically showing an exemplary configuration of a battery pack including the battery monitoring apparatus 100 according to an embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the first sensing line SL1, the second sensing line SL2 and the third sensing line SL3. Specifically, the measuring unit 20 may be connected to the positive electrode terminal of the battery 10 through the first sensing line SL1, and may be connected to the negative electrode terminal of the battery 10 through the second sensing line SL2. The measuring unit 20 may measure the voltage of the battery 10 based on the voltage measured at each of the first sensing line SL1 and the second sensing line SL2.

In addition, the measuring unit 20 may be connected to the current measuring unit 30 through the third sensing line SL3. For example, the current measuring unit 30 may be an ammeter or a shunt resistor capable of measuring the charging current and the discharging current of the battery 10. The measuring unit 20 may calculate the charge amount by measuring the charging current of the battery 10 through the third sensing line SL3. Also, the measuring unit 20 may calculate the discharge amount by measuring the discharging current of the battery 10 through the third sensing line SL3.

One end of the load 2 may be connected to the positive electrode terminal P+ of the battery pack 1, and the other end may be connected to the negative electrode terminal P- of the battery pack 1. Accordingly, the positive electrode terminal of the battery 10, the positive electrode terminal P+ of the battery pack 1, the load 2, the negative electrode terminal P- of the battery pack 1, and the negative electrode terminal of the battery 10 may be electrically connected.

For example, the load 2 may be a charging/discharging device, or a motor or the like of an electric vehicle that receives power from the battery 10.

FIG. 7 is a diagram schematically showing a battery monitoring method according to another embodiment of the present disclosure.

Preferably, each step of the battery monitoring method may be performed by the battery monitoring apparatus 100. Hereinafter, content overlapping with the previously described content will be omitted or briefly described.

Referring to FIG. 7, the battery monitoring method may include a differential profile generating step (S100), a curvature calculating step (S200), a curvature comparing step (S300), and a lithium precipitation judging step (S400).

The differential profile generating step (S100) is a step of generating a differential profile representing a corresponding relationship between a differential voltage representing a change rate of a voltage of a battery to a SOC of the battery and the SOC, and may be performed by the profile generating unit 110.

For example, the profile generating unit 110 may generate a differential profile representing a corresponding relationship between the SOC and the differential voltage (dV/dSOC) based on battery information (SOC and voltage) obtained in the discharging process of the battery.

The curvature calculating step (S200) is a step of calculating a curvature corresponding to a preset SOC region in the differential profile generated in the differential profile generating step (S100), and may be performed by the control unit 120.

The control unit 120 may determine a target peak in the preset SOC region and calculate a curvature corresponding to the determined target peak.

If there are a plurality of circles of curvature corresponding to the target peak, the control unit 120 may select a circle of curvature having a minimum curvature (with a maximum curvature radius) among the plurality of circles of curvature and calculate a curvature corresponding to the selected circle of curvature as the curvature corresponding to the target peak.

The curvature comparing step (S300) is a step of comparing the curvature calculated in the curvature calculating step (S200) with a preset criterion curvature for the battery, and may be performed by the control unit 120.

For example, the criterion curvature may be set when the battery is in a BOL state. That is, the criterion curvature may be set to correspond to a criterion peak included in a criterion profile for the battery in a BOL state.

The lithium precipitation judging step (S400) is a step of judging whether lithium is precipitated in the battery based on the comparison result of the curvature comparing step (S300), and may be performed by the control unit 120.

For example, the control unit 120 may judge whether lithium is precipitated in the battery based on a result of comparing the calculated curvature with the criterion curvature. Also, in order to more conservatively judge whether lithium is precipitated in the battery, the control unit 120 may further consider the number of times that the calculated curvature is greater than the criterion curvature and/or the increase/decrease pattern of the calculated curvatures.

The embodiments of the present disclosure described above are not necessarily implemented by an apparatus and method but may also be implemented through a program for realizing functions corresponding to the configuration of the present disclosure or a recording medium on which the program is recorded. Such implementation may be easily performed by those skilled in the art from the above description of the embodiments.

The present disclosure has been described in detail. However, it should be understood that the detailed description and specific examples, while indicating preferred embodiments of the disclosure, are given by way of illustration only. The invention is defined by the appended claims.

### (Reference Signs)

1: battery pack
2: load
10: battery
20: measuring unit
30: current measuring unit
100: battery monitoring apparatus
110: profile generating unit
120: control unit
130: storage unit

## Claims

1. A battery monitoring apparatus (100) comprising:
a profile generating unit (110) configured to generate a differential profile representing a corresponding relationship between a differential voltage representing a change rate of a voltage of a battery to a SOC of the battery and the SOC;
**characterized in** a control unit (120) configured to calculate a curvature corresponding to a preset SOC region in the differential profile, compare the calculated curvature with a preset criterion curvature for the battery, and judge whether lithium is precipitated in the battery based on the comparison result.

2. The battery monitoring apparatus according to claim 1,
wherein the control unit is configured to compare magnitudes of the calculated curvature and the criterion curvature.

3. The battery monitoring apparatus according to claim 2,
wherein the control unit is configured to judge that lithium is not precipitated in the battery, when the calculated curvature is equal to or smaller than the criterion curvature, and
wherein the control unit is configured to judge that lithium is precipitated in the battery, when the calculated curvature is greater than the criterion curvature.

4. The battery monitoring apparatus according to claim 2,
wherein the control unit is configured to calculate the number of times that the calculated curvature is greater than the criterion curvature and judge whether lithium is precipitated in the battery based on the calculated number of times.

5. The battery monitoring apparatus according to claim 4,
wherein the control unit is configured to judge that lithium is precipitated in the battery, when the calculated number of times is greater than a preset criterion value.

6. The battery monitoring apparatus according to claim 4,
wherein the profile generating unit is configured to generate a plurality of differential profiles, and
wherein the control unit is configured to calculate the curvature in each of the plurality of differential profiles generated by the profile generating unit and calculate the number of times that the plurality of calculated curvatures are greater than the criterion curvature.

7. The battery monitoring apparatus according to claim 4,
wherein, when the calculated number of times is greater than a preset criterion value, the control unit is configured to determine an increase/decrease pattern for a curvature judged as being greater than the criterion curvature and judge whether lithium is precipitated in the battery based on the determined increase/decrease pattern.

8. The battery monitoring apparatus according to claim 7,
wherein the control unit is configured to judge that lithium is precipitated in the battery, when the determined increase/decrease pattern is an increase pattern.

9. The battery monitoring apparatus according to claim 1,
wherein when it is judged that lithium is precipitated in the battery, the control unit is configured to generate and output a diagnosis code related to the lithium precipitation.

10. The battery monitoring apparatus according to claim 1,
wherein the control unit is configured to calculate an idle period of the battery and calculate the curvature for the differential profile generated by the profile generating unit when the calculated idle period is equal to or smaller than a preset criterion period.

11. The battery monitoring apparatus according to claim 1,
wherein the control unit is configured to determine a target peak included in the preset SOC region of the differential profile and calculate a curvature corresponding to the target peak.

12. A battery pack (1), comprising the battery monitoring apparatus (100) according to any one of claims 1 to 11.

13. A battery monitoring method, comprising:
a differential profile generating step (S100) of generating a differential profile representing a corresponding relationship between a differential voltage representing a change rate of a voltage of a battery to a SOC of the battery and the SOC;
**characterized in**
a curvature calculating step (S200) of calculating a curvature corresponding to a preset SOC region in the differential profile generated in the differential profile generating step;
a curvature comparing step (S300) of comparing the curvature calculated in the curvature calculating step with a preset criterion curvature for the battery; and
a lithium precipitation judging step (S400) of judging whether lithium is precipitated in the battery based on the comparison result of the curvature comparing step.

## Patentansprüche

1. Vorrichtung zur Batterieüberwachung (100), umfassend:
eine Profilerzeugungseinheit (110),
die so konfiguriert ist, dass sie ein Differenzprofil erzeugt, das eine entsprechende Beziehung zwischen einer Differenzspannung, die eine Änderungsrate einer Spannung einer Batterie zu einem Ladezustand der Batterie darstellt, und dem Ladezustand darstellt;
**gekennzeichnet durch**
eine Steuereinheit (120),
die so konfiguriert ist, dass sie eine Krümmung berechnet, die einem voreingestellten Ladezustandsbereich in dem Differenzprofil entspricht, die berechnete Krümmung mit einer voreingestellten Kriteriumskrümmung für die Batterie vergleicht und auf der Grundlage des Vergleichsergebnisses beurteilt, ob Lithium in der Batterie ausgefällt ist.

2. Vorrichtung zur Batterieüberwachung nach Anspruch 1,
wobei die Steuereinheit so konfiguriert ist, dass sie die Größen der berechneten Krümmung und der Kriteriumskrümmung vergleicht.

3. Vorrichtung zur Batterieüberwachung nach Anspruch 2,
wobei die Steuereinheit so konfiguriert ist, dass sie beurteilt, dass Lithium nicht in der Batterie ausgefällt ist, wenn die berechnete Krümmung gleich oder kleiner als die Kriteriumskrümmung ist, und
wobei die Steuereinheit so konfiguriert ist, dass sie beurteilt, dass Lithium in der Batterie ausgefällt ist, wenn die berechnete Krümmung größer als die Kriteriumskrümmung ist.

4. Vorrichtung zur Batterieüberwachung nach Anspruch 2,
wobei die Steuereinheit so konfiguriert ist, dass sie berechnet, wie oft die berechnete Krümmung größer als die Kriteriumskrümmung ist, und auf der Grundlage der berechneten Häufigkeit beurteilt, ob Lithium in der Batterie ausgefällt ist.

5. Vorrichtung zur Batterieüberwachung nach Anspruch 4,
wobei die Steuereinheit so konfiguriert ist, dass sie beurteilt, dass Lithium in der Batterie ausgefällt ist, wenn die berechnete Anzahl größer als ein voreingestellter Kriteriumswert ist.

6. Vorrichtung zur Batterieüberwachung nach Anspruch 4,
wobei die Profilerzeugungseinheit so konfiguriert ist, dass sie eine Vielzahl von Differenzprofilen erzeugt, und
wobei die Steuereinheit so konfiguriert ist, dass sie die Krümmung in jedem der Vielzahl von Differenzprofilen berechnet, die von der Profilerzeugungseinheit erzeugt werden, und berechnet, wie oft die Vielzahl der berechneten Krümmungen größer als die Kriteriumskrümmung ist.

7. Vorrichtung zur Batterieüberwachung nach Anspruch 4,
wobei, wenn die berechnete Anzahl größer ist als ein voreingestellter Kriteriumswert, die Steuereinheit so konfiguriert ist, dass sie ein Zu-/Abnahmemuster für eine Krümmung bestimmt, die als größer als die Kriteriumskrümmung beurteilt wird, und auf der Grundlage des bestimmten Zu-/Abnahmemusters beurteilt, ob Lithium in der Batterie ausgefällt ist.

8. Vorrichtung zur Batterieüberwachung nach Anspruch 7,
wobei die Steuereinheit so konfiguriert ist, dass sie beurteilt, dass Lithium in der Batterie ausgefällt ist, wenn das bestimmte Zu-/Abnahmemuster ein Zunahmemuster ist.

9. Vorrichtung zur Batterieüberwachung nach Anspruch 1,
wobei, wenn beurteilt wird, dass Lithium in der Batterie ausgefällt ist, die Steuereinheit so konfiguriert ist, dass sie einen Diagnosecode im Zusammenhang mit der Lithiumausfällung erzeugt und ausgibt.

10. Vorrichtung zur Batterieüberwachung nach Anspruch 1,
wobei die Steuereinheit so konfiguriert ist, dass sie einen Leerlaufzeitraum der Batterie und die Krümmung für das von der Profilerzeugungseinheit erzeugte Differenzprofil berechnet, wenn der berechnete Leerlaufzeitraum gleich oder kleiner als ein voreingestellter Kriteriumszeitraum ist.

11. Vorrichtung zur Batterieüberwachung nach Anspruch 1,
wobei die Steuereinheit so konfiguriert ist, dass sie einen Sollspitzenwert bestimmt, der in dem voreingestellten Ladezustandsbereich des Differenzprofils eingeschlossen ist, und eine Krümmung berechnet, die dem Sollspitzenwert entspricht.

12. Batteriepack (1), das die Vorrichtung zur Batterieüberwachung (100) nach einem der Ansprüche 1 bis 11 umfasst.

13. Verfahren zur Batterieüberwachung, umfassend:
einen Differenzprofilerzeugungsschritt (S100) des Erzeugens eines Differenzprofils, das eine entsprechende Beziehung zwischen einer Differenzspannung, die eine Änderungsrate einer Spannung einer Batterie zu einem Ladezustand der Batterie darstellt, und dem Ladezustand darstellt;
**gekennzeichnet durch**
einen Krümmungsberechnungsschritt (S200) des Berechnens einer Krümmung, die einem voreingestellten Ladezustandsbereich in dem im Differenzprofilerzeugungsschritt erzeugten Differenzprofil entspricht;
einen Krümmungsvergleichsschritt (S300) des Vergleichens der im Krümmungsberechnungsschritt berechneten Krümmung mit einer voreingestellten Kriteriumskrümmung für die Batterie; und
ein Lithiumausfällungsbeurteilungsschritt (S400) des Beurteilens, ob Lithium in der Batterie ausgefällt ist, basierend auf dem Vergleichsergebnis des Krümmungsvergleichsschritts.

## Revendications

1. Appareil (100) de surveillance de batterie, comprenant :
une unité (110) de génération de profil configurée pour générer un profil différentiel représentant une relation correspondante entre une tension différentielle représentant un taux de variation d'une tension d'une batterie par rapport à un état de charge (SOC) de la batterie et le SOC ;
**caractérisé par**
une unité de commande (120) configurée pour calculer une courbure correspondant à une région SOC prédéfinie dans le profil différentiel, comparer la courbure calculée à une courbure de critère prédéfinie pour la batterie, et juger si oui ou non le lithium est précipité dans la batterie sur la base du résultat de comparaison.

2. Appareil de surveillance de batterie selon la revendication 1,
dans lequel l'unité de commande est configurée pour comparer des grandeurs de la courbure calculée et de la courbure de critère.

3. Appareil de surveillance de batterie selon la revendication 2,
dans lequel l'unité de commande est configurée pour juger que le lithium n'est pas précipité dans la batterie, lorsque la courbure calculée est inférieure ou égale à la courbure de critère, et
dans lequel l'unité de commande est configurée pour juger que le lithium est précipité dans la batterie, lorsque la courbure calculée est supérieure à la courbure de critère.

4. Appareil de surveillance de batterie selon la revendication 2,
dans lequel l'unité de commande est configurée pour calculer le nombre de fois où la courbure calculée est supérieure à la courbure de critère et juger si oui ou non le lithium est précipité dans la batterie sur la base du nombre de fois calculé.

5. Appareil de surveillance de batterie selon la revendication 4,
dans lequel l'unité de commande est configurée pour juger que le lithium est précipité dans la batterie, lorsque le nombre de fois calculé est supérieur à une valeur de critère prédéfinie.

6. Appareil de surveillance de batterie selon la revendication 4,
dans lequel l'unité de génération de profil est configurée pour générer une pluralité de profils différentiels, et
dans lequel l'unité de commande est configurée pour calculer la courbure dans chacun de la pluralité de profils différentiels générés par l'unité de génération de profil et calculer le nombre de fois où la pluralité de courbures calculées sont supérieures à la courbure de critère.

7. Appareil de surveillance de batterie selon la revendication 4,
dans lequel, lorsque le nombre de fois calculé est une valeur de critère prédéfinie, l'unité de commande est configurée pour déterminer un modèle d'augmentation/diminution pour une courbure jugée comme étant supérieure à la courbure de critère et juger si oui ou non le lithium est précipité dans la batterie sur la base du modèle d'augmentation/diminution déterminé.

8. Appareil de surveillance de batterie selon la revendication 7,
dans lequel l'unité de commande est configurée pour juger que le lithium est précipité dans la batterie, lorsque le modèle d'augmentation/diminution déterminé est un modèle d'augmentation.

9. Appareil de surveillance de batterie selon la revendication 1,
dans lequel lorsqu'on juge que le lithium est précipité dans la batterie, l'unité de commande est configurée pour générer et sortir un code de diagnostic relatif à la précipitation de lithium.

10. Appareil de surveillance de batterie selon la revendication 1,
dans lequel l'unité de commande est configurée pour calculer une période d'inactivité de la batterie et calculer la courbure pour le profil différentiel généré par l'unité de génération de profil lorsque la période d'inactivité calculée est inférieure ou égale à une période de critère prédéfinie.

11. Appareil de surveillance de batterie selon la revendication 1,
dans lequel l'unité de commande est configurée pour déterminer un pic cible inclus dans la région SOC prédéfinie du profil différentiel et calculer une courbure correspondant au pic cible.

12. Bloc-batterie (1), comprenant l'appareil (100) de surveillance de batterie selon l'une quelconque des revendications 1 à 11.

13. Procédé de surveillance de batterie, comprenant :
une étape (S100) de génération de profil différentiel, consistant à générer un profil différentiel représentant une relation correspondante entre une tension différentielle représentant un taux de variation d'une tension d'une batterie par rapport à un état de charge (SOC) de la batterie et le SOC ;
**caractérisé par**
une étape (S200) de calcul de courbure, consistant à calculer une courbure correspondant à une région SOC prédéfinie dans le profil différentiel généré dans l'étape de génération de profil différentiel ;
une étape (S300) de comparaison de courbure, consistant à comparer la courbure calculée à l'étape de calcul de courbure à une courbure de critère prédéfinie pour la batterie ; et
une étape (S400) de jugement de la précipitation de lithium, consistant à juger si oui ou non le lithium est précipité dans la batterie sur la base du résultat de comparaison de l'étape de comparaison de courbure.
